# FASCICULE DE BREVET EUROPEEN

(11) **EP 1 966 744 B1**
(45) Date de publication et mention de la délivrance du brevet: **26.10.2011**
(21) Numéro de dépôt: 06847124.2
(22) Date de dépôt: 22.12.2006
(51) Int. Cl.: G06K 19/077, B29C 45/14

(54) **PROCEDE DE FABRICATION D UNE CARTE A MICROCIRCUIT**
VERFAHREN ZUR HERSTELLUNG EINER MIKROCHIPKARTE
METHOD FOR PRODUCING A MICROCHIP CARD

(30) Priorité: 26.12.2005 FR 0513319
(43) Date de publication de la demande: 10.09.2008
(73) Titulaire: OBERTHUR TECHNOLOGIES, 92300 Levallois Perret (FR)
(72) Inventeur: LAUNAY, François, F- 35500 Vitre (FR)
(74) Mandataire: Quantin, Bruno Marie Henri
(86) Numéro de dépôt international: PCT/FR2006/002854
(87) Numéro de publication internationale: WO 2007/077355

(56) Documents cités:
- EP-A- 0 969 410
- EP-A1- 0 277 854
- WO-A-98/09252
- DE-A- 10 148 105
- DE-A- 10 216 652
- DE-A1- 10 148 105
- DE-A1- 10 216 652
- DE-A1- 10 334 578
- DE-A1- 19 716 912
- FR-A- 2 702 067
- FR-A1- 2 702 067
- US-A- 5 800 763
- US-A- 5 850 690

## Description

La présente invention concerne un procédé de fabrication de carte à microcircuit et des cartes à microcircuit associées.

L'invention se rapporte à une carte à microcircuit comprenant les cartes à microprocesseur, les cartes à mémoire telle qu'une carte mémoire de stockage de données numériques (carte « Secure Digital » ou carte SD), les cartes smartmedia ou les mini cartes multimédia.

Les cartes à microcircuit comprennent essentiellement un corps de carte qui est réalisé en général en un matériau plastique et un module électronique.

Ce module électronique comprend notamment un microcircuit sous la forme d'un circuit intégré et d'un circuit imprimé sur lequel est fixé le circuit intégré et qui définit des plages externes de contacts électriques. Le module électronique est fixé dans le corps de la carte de manière à ce que les plages de contacts électriques affleurent une des faces principales du corps de carte.

Les spécifications d'une telle carte à microcircuit sont par exemple celles définies par la norme ISO 7816. On parle dans ce cas de carte à puce. Selon cette norme, l'épaisseur de la carte est d'environ 0,76 mm. Dans ce cas, le microcircuit est apte à communiquer avec un lecteur de carte à puce selon la norme ISO 7816, par exemple en utilisant le protocole appelé « T=0 ».

Toutefois, l'épaisseur de la carte peut être quelconque.

La carte est apte à être positionnée dans le lecteur de carte de telle manière que les plages de contacts de la carte viennent en contact électrique avec le connecteur du lecteur de carte.

Selon un autre exemple de réalisation, le microcircuit peut comprendre une mémoire flash, un capteur d'empreinte, un écran, un capteur solaire.

Une méthode d'assemblage très utilisée consiste à réaliser le support plastique par des procédés de laminage ou d'injection de matières thermoplastiques et ensuite à coller le module électronique dans une cavité du support plastique réalisée à cet effet. Cette dernière opération est connue sous le terme « encartage ».

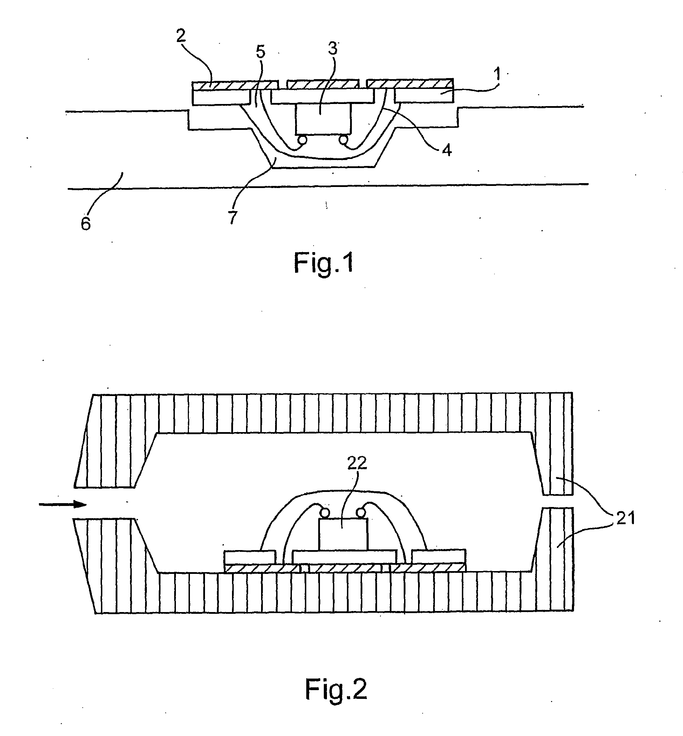

Ainsi la figure 1 illustre l'opération d'encartage. Le module électronique 1 comprend des contacts électriques externes 2 aptes à être mis en connexion dans un lecteur de carte et un microcircuit 3 comprenant par exemple un microprocesseur ou un module mémoire. Le microcircuit 3 est relié aux contacts électriques externes 2 par des fils de connexion électrique 4. Afin de protéger le module électronique, une résine 5 protége le microcircuit 3 et les fils de connexion électrique 4. Un corps de carte 6 en matière plastique est fabriqué et comprend une cavité 7 apte à accueillir le module électronique 1. Le module électronique 1 est ensuite fixé dans la cavité 7.

Afin de supprimer cette étape d'encartage, on connaît du document EP0277854 intitulé « Procédé de réalisation de cartes à mémoire et cartes obtenues par la mise en oeuvre dudit procédé », un procédé de moulage par injection.

Ce procédé est basé sur l'utilisation d'un moule 21 ayant la forme du corps de la carte souhaitée tel qu'illustré en figure 2. Il comprend l'insertion d'un module électronique 22 dans le moule 21 et le maintien en place du module électronique 22 de telle manière que la face d'accès du module électronique 22 soit disposée contre une paroi du moule. Ensuite, on introduit dans le moule un matériau plastique de telle manière que le matériau plastique occupe la totalité de l'espace limité par les parois du moule non occupé par le module électronique.

Cependant, un tel système présente l'inconvénient d'être un procédé de fabrication complexe. De même, le maintien du module électronique en position dans le moule nécessite des méthodes particulières, notamment réalisées à partir de picots ou de pistons, ce qui a pour conséquence d'augmenter le coût des moules.

Ainsi, lorsqu'il est fabriqué une carte par moulage, un besoin permanent est de réduire les coûts de fabrication et simplifier les équipements.

L'invention propose à cet effet un procédé de fabrication de cartes à microcircuit comprenant les étapes suivantes :
- une étape de positionnement d'un microcircuit dans un moule à cavité ouverte,
- une étape de dépôt d'un matériau dans la cavité ouverte du moule, le matériau étant suffisamment peu visqueux pour enrober au moins indirectement au moins une partie du microcircuit ; et
- une étape de démoulage du matériau avec le microcircuit.

En effet, dans un souci de simplification du procédé de fabrication d'une carte à microcircuit et de réduction du coût de celle-ci, on fabrique ladite carte à microcircuit par le dépôt d'un matériau dans un moule ouvert.

Le moule ouvert est de fabrication simplifiée comparé à un moule de type à injection et donc de moindre coût.

De plus, ce procédé ne nécessite nullement de presse de transfert ou de mécanisme d'injection.

La cavité ouverte est notamment de la forme de la carte à microcircuit à fabriquer.

Le matériau utilisé doit être suffisamment liquide (peu visqueux) pour que celui-ci vienne enrober au moins indirectement au moins une partie du microcircuit (éventuellement par l'intermédiaire d'une résine d'enrobage ou similaire). Plus le matériau est liquide, meilleur est le remplissage de la cavité du moule (ainsi qu'avantageusement la future liaison mécanique entre ce matériau et le microciruit) et plus grandes peuvent être les cadences de production industrielle.

De plus, ce procédé de fabrication peut nécessiter seulement l'utilisation de faibles températures. Par conséquent, ce procédé est sans incidence sur le microcircuit de la carte.

Diverses caractéristiques avantageuses, isolées ou combinées, peuvent être mises en oeuvre selon l'invention.

Selon un mode de réalisation, la viscosité du matériau permet après dépôt d'obtenir une surface libre sensiblement lisse.

Selon cette caractéristique, le fait que la surface soit lisse (et avantageusement plane) a pour effet de minimiser les traitements ultérieurs sur cette surface.

De plus, ce matériau est avantageusement d'une fluidité permettant sa répartition, notamment homogène dans le moule.

Selon un mode de réalisation, le dépôt est réalisé par coulée dans le moule.

De manière avantageuse, la viscosité du matériau est inférieure à 10.000 mPa.s. Toutefois, il est préféré que la viscosité du matériau soit comprise entre 500 et 5.000 mPa.s ou entre 50 et 100 mPa.s.

Selon un mode de réalisation, la cavité ouverte du moule est avantageusement de la forme de la carte à microcircuit.

Selon une caractéristique avantageusement, le matériau est un matériau polymérisable.

De manière préférentielle, le matériau comprend principalement une résine thermodurcissable. Il peut comprendre en outre un durcisseur.

En outre, la résine est par exemple du polyuréthane.

Selon un mode de réalisation, le matériau comprend une charge afin notamment d'ajuster la viscosité.

Selon des modes de réalisation particuliers, le procédé comprend avantageusement une étape de durcissement du matériau déposé et / ou une étape de chauffage du matériau déposé et / ou une étape de pré-chauffage du moule.

Elle permet, dans le cadre industriel impliquant des cadences importantes de bien contrôler le durcissement de la carte à puce.

Le document DE 197 16 912 enseigne d'adapter les propriétés de durcissage d'un matériel adhésif utilisé pour fixer un module dans un corps de carte aux conditions du procédé de laminage utilisé pour déposer une couche de couverture sur la carte.

Le document US5850690 enseigne l'utilisation d'une disposition alternée dans une cavité, de pistes de contact pour un microcircuit, combinée à l'utilisation d'un adhésif non conducteur, à une soudure des fils conducteurs et à l'utilisation d'une résine de protection.

Le document EP 0969410 enseigne, dans une carte comprenant une antenne, d'utiliser une cavité ayant une première partie où doit être placé le microcircuit et un prolongement latéral, en combinaison avec des pistes conductrices.

Le document US 5800763 enseigne l'utilisation d'une presse pour former un corps de support de données incorporant un ou des éléments de stockage de données, en combinaison avec le chauffage d'un composé de moulage granulaire ou en poudre.

De manière à conférer à la carte à microcircuit fabriquée la rigidité requise, le procédé comprend, avantageusement, en outre une étape de polymérisation.

Pour ce faire, la résine est avantageusement choisie en sorte d'avoir, après l'étape de polymérisation, une température de transition vitreuse supérieure à 50°C.

Dans le cadre de la fabrication de carte à microcircuit de téléphonie mobile, la résine est avantageusement choisie en sorte d'avoir, après l'étape de polymérisation, une température de transition vitreuse supérieure à 70°C.

Selon un mode de réalisation particulier, la résine est avantageusement choisie en sorte d'avoir une dureté du matériau supérieure à 70 Shore D.

Selon une variante de réalisation, l'étape de dépôt du matériau est avantageusement réalisée postérieurement à l'étape de positionnement du microcircuit.

Avantageusement, le moule comprend au moins un trou réalisé au fond du moule en vu de maintenir en position le microcircuit par aspiration.

Selon cette caractéristique, le positionnement du microcircuit est simplifié et permet d'obtenir un maintien de celui-ci durant la phase de la fabrication dans le moule de la carte à microcircuit.

D'autre part, au moyen du trou, il est rendu aisé le démoulage de la carte à microcircuit après sa fabrication.

Selon un mode de réalisation particulier, le microcircuit comprend avantageusement des contacts externes, les contacts externes étant positionnés contre le fond du moule.

Avantageusement, ledit au moins un trou est positionné au niveau du positionnement des contacts externes de telle manière que le maintien des contacts externes est amélioré.

Selon une variante de réalisation, l'étape de dépôt du matériau est réalisée préalablement à l'étape de positionnement du microcircuit,

Selon cette variante, le microcircuit comprend des contacts externes, les contacts externes étant positionnés au niveau de la surface du matériau déposé préalablement à un durcissement complet.

Selon un autre mode de réalisation, le microcircuit est avantageusement fixé à un film de support.

Ce film de support porte, avantageusement, des contacts externes.

Avantageusement, le film comprend sur une face les contacts externes et sur l'autre face, le microcircuit, des interconnexions étant établies entre des bornes du microcircuit et au moins certains des contacts externes:

Le film de support peut également comporter en outre au moins une partie d'une antenne, ladite antenne pouvant être, avantageusement, reliée au microcircuit.

Selon un mode de réalisation, l'antenne est avantageusement présente sur la face du film de support munie du microcircuit.

Avantageusement, le film de support est fixé par au moins une extrémité au moule et / ou par des gouttes de matériau. Selon cette caractéristique, on assure un bon maintien du film de support dans le moule durant la phase de fabrication dans le moule de la carte à microcircuit.

Selon un mode de réalisation particulier, le microcircuit est fixé au film de support par l'intermédiaire d'une couche d'adhésif positionnée sur ce film de support. Selon cette caractéristique, le microcircuit est maintenu positionné au moyen de l'adhésif sur le film dans le moule sans nécessité, par exemple, un trou d'aspiration.

Selon une caractéristique particulière, les contacts externes du microcircuit sont fixés au film de support par l'intermédiaire de ladite couche d'adhésif.

Selon une autre caractéristique particulière, le film de support est retiré pour libérer les contacts du microcircuit.

Selon une autre variante de réalisation de l'invention, le microcircuit étant fixé sur un film de support, il y a avantageusement une étape de fixation du film de support à un niveau intermédiaire dans le moule de sorte que le matériau enrobe le film de support.

Selon cette caractéristique, on fixe le film de support de manière à ce que, par exemple, le matériau enrobe le film et forme, notamment, une carte comportant en son coeur, le microcircuit. Cette carte peut être une carte sans contact, mais également une carte à contact dans laquelle le microcircuit est enrobé dans le matériau.

Avantageusement, le film de support est muni d'au moins une partie d'une antenne.

Selon un mode de réalisation, le film de support comprend avantageusement des trous permettant de répandre le matériau.

Selon un autre mode de réalisation, le film de support est avantageusement maintenu à distance de certains côtés du moule.

Selon encore un autre mode de réalisation, le film de support est avantageusement maintenu par des gouttes de matériau.

Selon une autre variante de réalisation, le microcircuit est avantageusement fixé sur un film de support, le procédé comprenant les étapes suivantes :
- une étape de remplissage du fond du moule par un premier dépôt de matériau ;
- une étape de positionnement du film de support dans le matériau ;
- une étape consistant à recouvrir le film de support par remplissage dans le moule par un second dépôt de matériau.

Selon ce mode de réalisation, on fabrique des cartes à microcircuit sans contact. Toutefois, ce mode de réalisation est applicable à des cartes à contact par fixation de contacts externes à la surface de la carte et en effectuant des liaisons électrique de ces contacts externes jusqu'au microcircuit.

Selon un mode de réalisation particulier, le film de support est muni d'au moins une partie d'une antenne.

De la sorte, la carte à puce peut être une carte sans contact ou une carte duale.

De préférence, la carte fabriquée est conforme à la norme ISO 7816 avec une épaisseur sensiblement égale à 0,76 mm.

L'invention et les avantages qui en découlent apparaîtront plus clairement à la lecture de la description qui décrit des modes de réalisation donnés purement à titre d'exemples non-limitatifs, par référence aux dessins annexés dans lesquels :
La figure 1 est une carte fabriquée selon un procédé d'encartage selon l'état de la technique ;
La figure 2 est une carte fabriquée par injection selon l'état de la technique ;
La figure 3 est une représentation schématique d'un moule ouvert ;
La figure 4 est une représentation schématique d'un film de support comprenant sur la face externe un ensemble de motifs ;
La figure 5 est une représentation schématique du film de support comprenant sur la face interne des microprocesseurs ;
La figure 6 est une représentation schématique d'un microcircuit fixé sur un film de support de type puce montée-retournée ;
La figure 7 est une illustration du positionnement du microcircuit dans le moule selon l'invention ;
La figure 8 illustre la carte à microcircuit dans un moule selon l'invention ;
La figure 9 illustre l'utilisation d'une râpe selon l'invention ;
La figure 10 illustre le dépôt de matériau dans le moule préalablement au positionnement du microcircuit ;
La figure 11 est une représentation schématique de la couche de matériau sur lequel le microcircuit va être positionné ;
La figure 12 est une représentation schématique d'un microcircuit fixé sur la couche de matériau dans le moule ;
La figure 13 illustre un film comprenant une seule voie de contacts ;
La figure 14 illustre un film comprenant une seule voie de contacts et de microcircuits ;
La figure 15 illustre un moule composé d'éléments amovibles ;
La figure 16 est une vue de dessus des moules ;
La figure 17 illustre un support pour carte sans contact ;
La figure 18 est une représentation schématique d'un support de carte sans contact ;
La figure 19 est une représentation schématique d'un premier mode de réalisation d'une carte sans contact selon l'invention ;
La figure 20 est une représentation schématique d'un second mode de réalisation d'une carte sans contact selon l'invention ;
La figure 21 est une variante de réalisation du second mode de réalisation d'une carte sans contact selon l'invention ;
La figure 22 est une illustration du dépôt de matériau dans le moule en vue de fabriquer une carte sans contact selon un troisième mode de réalisation ;
La figure 23 est une illustration du positionnement de l'inlay dans le moule en vue de fabriquer une carte sans contact selon le troisième mode de réalisation ;
La figure 24 est une illustration du dépôt d'une seconde couche de matériau dans le moule en vue de fabriquer une carte sans contact selon le troisième mode de réalisation ; et
La figure 25 est un autre mode de réalisation d'un moule composé d'éléments amovibles.

L'invention consiste à réaliser une carte, notamment une carte à microcircuit par un procédé de moulage faible coût utilisant la dispense, aussi appelée la coulée d'un matériau, notamment de la résine polyuréthane, dans un moule ouvert.

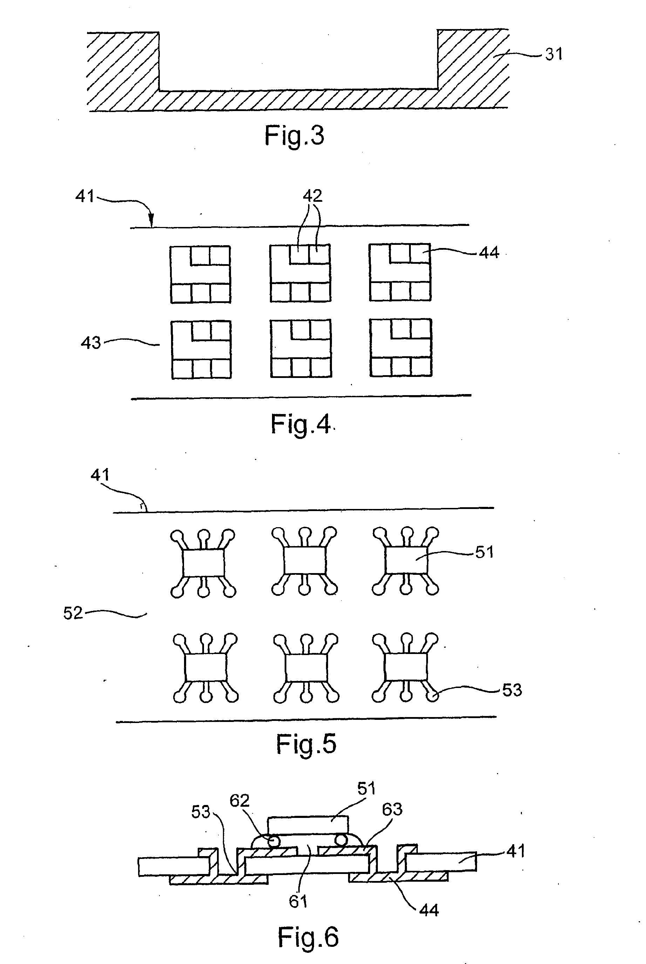

Pour ce faire, le procédé utilise un moule ouvert 31 présentant une cavité débouchant tel qu'illustré en figure 3. Le moule comprend une cavité ouverte définissant une empreinte qui donne la forme externe du corps de la carte souhaitée. Pour cela, celui-ci a la forme et les dimensions en largeur et longueur de la carte souhaitée, diminuant ainsi le coût de fabrication.

Le moule peut prendre la forme d'une carte à microcircuit c'est-à-dire être au format carte bancaire définie par la norme ISO-7816, mais également peut prendre la forme d'une mini-carte telle qu'une carte SIM notamment conforme à la norme ISO7816 ou d'une SD-Card.

Selon une variante de réalisation, le moule est de la forme d'un support intermédiaire utilisé ultérieurement comme partie constituante de la carte à microcircuit définitive. Ce support intermédiaire est par exemple un module composé d'un support comprenant un microcircuit ou une mémoire, ou tout autre forme.

Dans un mode de réalisation, le microcircuit utilisé comprend, notamment, un ou plusieurs microprocesseurs et/ou une ou plusieurs mémoires ainsi qu'un film support pouvant porter des contacts internes et externes.

Ce film support peut également comprendre un écran, un capteur optique d'empreinte digitale, ou un système micromécanique ou micro-optique.

Selon une variante de réalisation, le microcircuit peut être présent dans l'épaisseur du film de support ou dans une cavité du film de support prévue à cet effet.

L'épaisseur du film de support est variable selon les matériaux utilisés. Elle se situe en moyenne entre 50 µm et 200 µn.

Ainsi, un film de support où les contacts et les microcircuits sont positionnés est illustré en figures 4 et 5. Le film de support 41 est, notamment, en matériau flexible comprenant une pluralité de motifs 42, jouant le rôle de contacts externes 44 pour chaque microcircuit. Ces motifs sont fixés notamment sur une face du film 41 appelée face externe 43.

Des microcircuits 51, comprenant par exemple un microprocesseur ou une mémoire, sont fixés sur la face opposée aux contacts externes c'est-à-dire sur la seconde face du film de support 41 aussi appelée face interne 52 du film de support 41 tel qu'illustré en figure 5. De la sorte, un microcircuit 51 est collé sur la face interne 52 du film de support à chaque emplacement de contact externe 44 de telle manière que chaque motif de contacts externes comporte un microcircuit.

Selon un mode de réalisation particulier, les contacts externes 44 et le microcircuit 51 ne sont pas à proximité mais éloignés sur le film de support 41. La liaison entre les contacts externes 44 et le microcircuit 51 est assurée par des lignes conductrices sur ou dans le film de support.

Selon une autre variante de réalisation, le microcircuit 51 peut être présent dans l'épaisseur du film de support 41 ou dans une cavité du film de support prévue à cet effet.

Ensuite, des connexions électriques 53 sont réalisées entre les bornes de connexion du microcircuit 51 et au moins un contact d'un motif de contacts externes 44 porté par la face externe 43 du film de support.

On obtient ainsi une bande formée par le film de support 41 qui comporte sur une de ses faces une pluralité de motifs, chaque motif comportant de plus un microcircuit 51 qui lui est associé sur la face opposée du film.

Le film de support peut notamment être un film en verre époxy, en PET (poly éthylène térephtalate) ou en polyimide.

En variante de réalisation, le microcircuit 51 n'est pas monté sur un film de support mais est sous la forme d'un microcontrôleur et d'une antenne formant un circuit intégré.

La connexion des contacts externes 44 et du microcircuit 51 au travers du film de support 41 peut être obtenue par un procédé de puce montée-retournée (« Flip-chip » en terminologie anglo-saxonne) tel qu'illustré en figure 6.

Selon ce procédé, les contacts externes 44 sont positionnés sur la face externe 43 du film de support 41. Sur la face interne 52 du film de support 41, on a le microcircuit 51 qui est positionné et qui est connecté à des pistes conductrices 53. Les pistes conductrices 63 relient le microcircuit 51 et les contacts externes 44 au moyen de connexion électrique 53, notamment réalisée par des trous métallisés aussi appelés « vias » métallisés. Le microcircuit 51 est fixé par un élément tel que de la colle 61 isolante ou conductrice anisotrope. De même, la connexion entre le microcircuit 51 et les pistes conductrices 63 est réalisée par une surépaisseur conductrice 62 aussi appelée « bump » en terminologie anglo-saxonne.

Selon un autre mode de réalisation dans lequel la puce n'est pas montée - retournée (« Flip-Chip »), la connexion des contacts externes 44 et du microcircuit 51 au travers du film de support 41 peut être obtenue par un procédé de soudure filaire entre le microcircuit et les pistes conductrice 63.

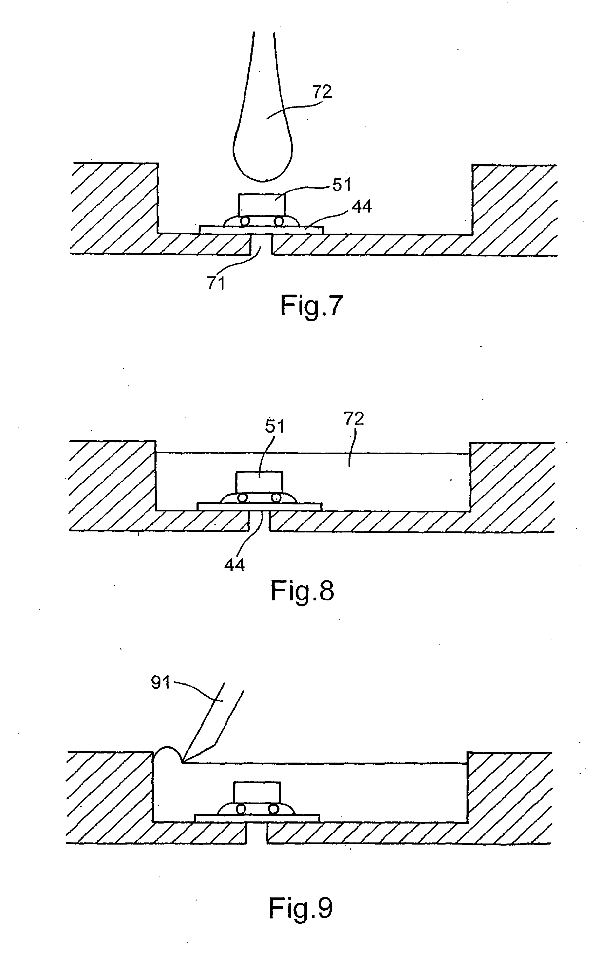

Selon un mode de réalisation de l'invention, chaque microcircuit individuel est découpé du film de support et est positionné dans le moule ouvert. Les contacts externes du microcircuit sont positionnés contre le fond du moule tel que montré en figure 7.

Dans le cas des cartes à microcircuit, la position est définie par la norme internationale ISO, notamment dans la norme ISO 7816.

Le microcircuit peut être maintenu pendant l'opération de moulage, par exemple, par une aspiration passant par un trou réalisé 71 dans le fond du moule 31 à l'emplacement voulu. Ce trou peut également permettre, ultérieurement, le démoulage de la carte fabriquée.

Dans le cas d'utilisation d'un film de support comprenant le microcircuit, celui-ci est placé au fond du moule, et le trou d'aspiration maintien le film de support positionné durant la phase de fabrication.

Selon encore une autre variante de réalisation, on peut maintenir le film de support par le dépôt de gouttes de matériau en périphérie du film de support.

Un matériau 72 est ensuite déposé, notamment par coulée, dans le moule contenant le microcircuit de sorte à enrober au moins indirectement au moins une partie du microcircuit, le microcircuit pouvant être lui-même enrobé au moins en partie par une résine. Cet enrobage contribue à une bonne adhérence du matériau avec le microcircuit. Ce matériau est par exemple une résine polyuréthane. Il peut s'agir, notamment, de la résine F31 d'Axson. Ce matériau doit également avoir des propriétés de mouillage adaptées de manière à ce que ce matériau rentre en contact au moins en partie et au moins indirectement avec le microcircuit.

La quantité de matériau déposé, notamment par coulée, dans le moule est calculée de façon à remplir le moule jusqu'à atteindre le niveau d'épaisseur recherché pour la carte à microcircuit. Une carte fabriquée conformément à la norme ISO 7816 est d'épaisseur à peu près de 0,76 mm.

Bien entendu le dépôt peut être effectué à un emplacement donné ou à une pluralité d'emplacements simultanément, en utilisant par exemple une pluralité de buses de dépôt. Une telle utilisation présente l'avantage de fabriquer un grand nombre de cartes à microcircuits rapidement.

Le matériau de dépôt est notamment obtenu par le mélange d'une résine polyuréthane de base et d'un durcisseur pour permettre la polymérisation de la résine.

La viscosité du mélange doit permettre de remplir la surface du moule définissant la carte de façon satisfaisante, d'obtenir une épaisseur homogène sur toute ladite surface et obtenir une surface libre sensiblement lisse et avantageusement plane tel que montré en figure 8.

Pour ce faire, le matériau peut également comprendre une charge, par exemple du dioxyde de titane afin d'ajuster la viscosité.

A cet effet, la viscosité du mélange à 25°C doit être inférieure à 10.000 mPa.s. De manière préférentielle, la viscosité est de l'ordre de quelques milliers de mPa.s à 25°C et avantageusement entre 500 et 5.000 mPa.s.

Selon un mode de réalisation avantageux, la résine est par exemple la résine F31 d'Axson, de viscosité est comprise entre 50 et 100 mPa.s et ayant une température de transition vitreuse supérieure à 50°.

Il est à noter qu'une faible température suffit pour la fabrication de telles cartes à microcircuit. De la sorte, le procédé et très peu stressant pour le film, le microprocesseur ou la mémoire, et les connections entre le microcircuit et les contacts externes, ces connexions étant soit réalisées par un procédé de soudure filaire ou par un procédé de puce montée - retournée.

Selon une variante de réalisation, on utilise une racle 91, comme illustré en figure 9 pour homogénéiser l'épaisseur de la carte à microcircuit.

Le moule peut aussi être préchauffé pour accélérer le gel ou le durcissement du matériau déposé et optimiser sa répartition dans le moule ouvert. Les températures de préchauffage sont faibles, notamment de l'ordre de 40°C pour éviter un durcissement du matériau avant qu'il n'ait rempli le moule.

De même, on peut procéder à un durcissement du matériau par d'autres techniques telles que le durcissement par UV.

Ces techniques de durcissement du matériau ont pour but de contrôler et / ou d'accélérer sensiblement le procédé de fabrication des cartes à microcircuit. En effet, dans un contexte industriel, cette étape de durcissement permet d'augmenter sensiblement la productivité de fabrication de cartes à microcircuit fabriquées par dépôt de matériau dans un moule ouvert.

Selon un mode de réalisation particulier, le matériau utilisé a une température de transition vitreuse après polymérisation supérieure à 50°C et une dureté supérieure à 70 Shore D, afin de résister aux variations de température durant son utilisation et être suffisamment rigide pour pouvoir être inséré sans problème dans un connecteur, par exemple, un lecteur de carte à microcircuit.

Pour une mini-carte, notamment les cartes d'identification de téléphonie mobile SIM ou USIM, la température de transition vitreuse se situe au-dessus de 70°C en raison d'une possible montée en température dans le téléphone en fonctionnement.

Des moyens de chauffage externes sur la surface libre de la carte peuvent aussi être utilisés pour accélérer le durcissement. On peut, par exemple, utiliser des températures assez faibles de l'ordre de 25°C à 100°C.

Ensuite, la carte à microcircuit est démoulée.

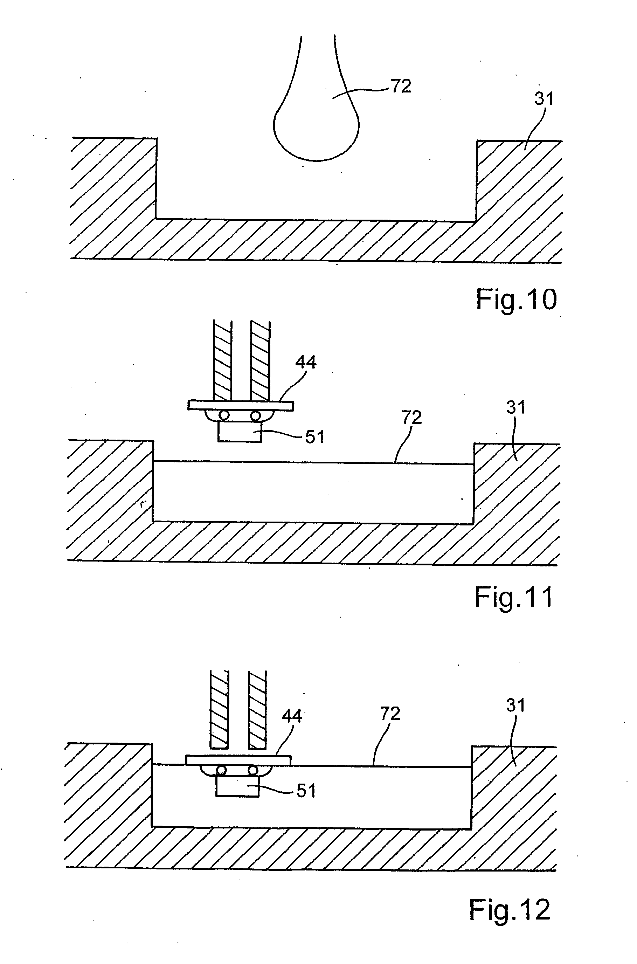

Selon un autre mode de réalisation de l'invention, le procédé de fabrication de la carte à microcircuit débute par le dépôt, notamment par coulée, du matériau dans le moule, préalablement au positionnement du microcircuit tel que montré en figure 10.

Pour ce faire, on procède au dépôt d'une couche de matériau d'une épaisseur conforme à la carte à microcircuit souhaitée, notamment une épaisseur de 0,76 mm pour une carte conforme à la norme ISO 7816, tel qu'illustré en figure 11.

Ensuite, on procède au positionnement du microcircuit 51 à la surface du matériau déposé, tout en prenant bien soin à ce que les contacts externes connectés au microcircuit restent à la surface du matériau tel qu'illustré en figure 12.

Enfin, on procède à la polymérisation de la structure ainsi obtenue. On rend ainsi rigide la carte à microcircuit.

Selon une autre variante de réalisation de l'invention, on peut réaliser les cartes à microcircuit sur le film de support comprenant des microcircuits sans toutefois détacher ceux-ci du film de support.

Selon encore une autre variante de réalisation de l'invention, au lieu d'utiliser un film de support double voie, c'est-à-dire ayant en parallèle deux séries de motifs de contacts, tel qu'illustré aux figures 3 et 4, on utilise un film de support comprenant une seule série de motifs de contacts, ce film est alors appelé film monovoie.

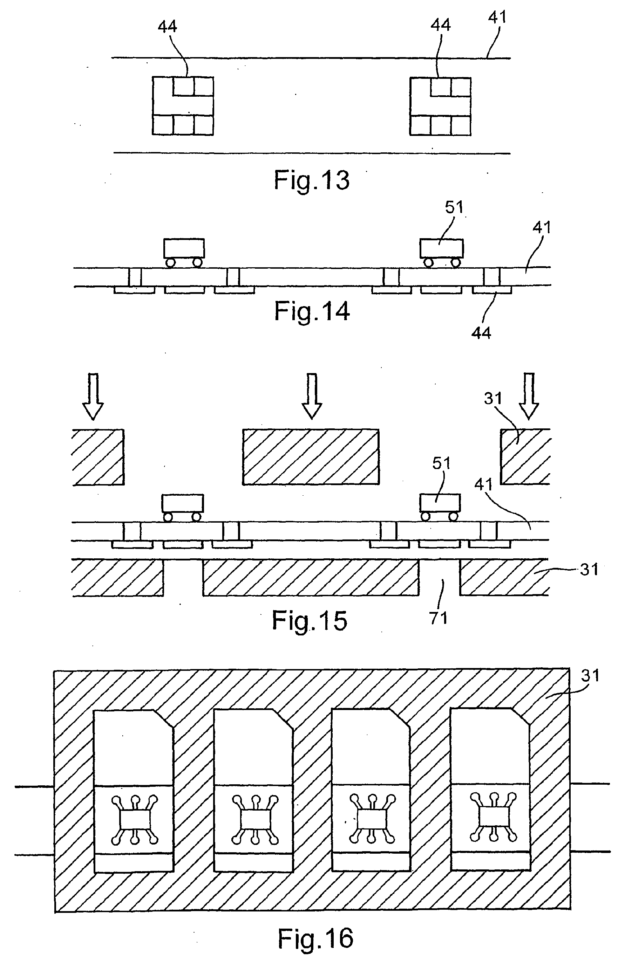

Selon un mode de réalisation, les microcircuits positionnés sur le film de support sont espacés d'une distance strictement supérieure à la largeur d'une carte telle qu'illustré aux figures 13 et 14.

Selon un mode de réalisation particulier, le moule est constitué de deux parties. Une première partie comprend un support plan sur lequel vient reposer le film et une seconde partie comprend une partie amovible définissant les dimensions latérales de la carte à microcircuit souhaitée.

Après avoir procédé au positionnement du film sur le support plan, la partie amovible du moule vient se rabattre sur le film tel que montré en figure 15.

Le moule ainsi monté est prêt pour réaliser l'opération de moulage de la carte à microcircuit.

Le film de support peut également être maintenu au fond du moule, pendant l'opération de moulage, par exemple, par une aspiration passant par un trou 71 réalisé dans le fond du moule 31 à l'emplacement voulu.

On procède ainsi au dépôt de matériau dans le moule. La figure 16 illustre une vue de dessus des moules montrant le lot de cartes à microcircuit à réaliser, les moules contenant les microcircuits 51.

Le procédé précédemment décrit s'applique également à la réalisation d'une carte à microcircuit sans contact contenant un film de support comprenant une antenne et notamment au moins un microcircuit.

Le microcircuit peut être un microprocesseur ou une mémoire connectée directement à l'antenne, par exemple, par un procédé de fabrication de puce montée montée-retournée ou par un procédé de soudure filaire.

Selon une variante, le microcircuit comprend un microprocesseur ou une mémoire pré-assemblée dans un module, ce dernier étant connecté à l'antenne.

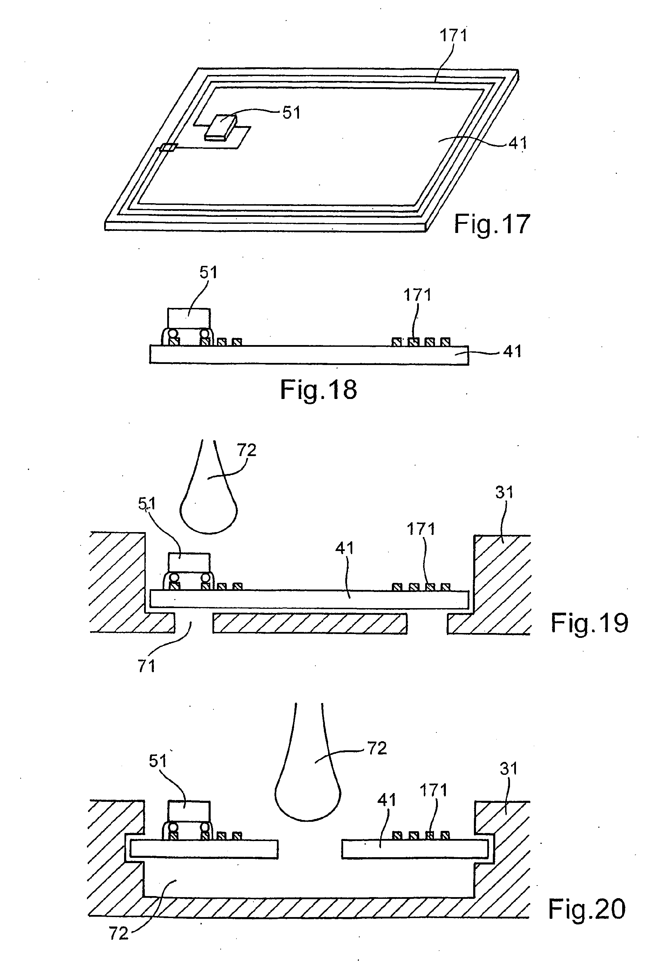

Les figures 17 et 18 montrent une feuille de support 41 sur laquelle est fixé un microprocesseur ou une mémoire qui est connecté directement par un procédé de fabrication de puce montée montée-retournée à l'antenne 171 en vue de fabriquer une carte à microcircuit sans contact.

Cet ensemble constitué de la feuille de support, de l'antenne et du microprocesseur est appelé « inlay » en terminologie anglo-saxonne.

L'inlay ainsi constitué peut être utilisé pour la fabrication de la carte à microcircuit.

Selon un premier mode de réalisation d'une carte à antenne illustré en figure 19, on positionne l'inlay au fond du moule ouvert et on dépose, par exemple par coulée, le matériau sur la face de l'inlay contenant le microprocesseur ou la mémoire et l'antenne.

Le positionnement de l'inlay et le maintien en position au fond du moule peuvent être effectués par des moyens d'aspiration au travers de trous 71 réalisés dans le fond du moule tel qu'illustré en figure 19.

Le dépôt de matériau sur l'inlay est consiste à coulée une quantité de ce matériau de sorte à obtenir l'épaisseur souhaitée.

Selon un second mode de réalisation d'une carte à antenne illustré en figure 20, on positionne à un niveau intermédiaire l'inlay dans le moule ouvert de manière à ce que l'inlay soit positionné à l'intérieur de la structure de carte. Ce niveau intermédiaire est situé à peu près au milieu de l'épaisseur souhaitée de la carte à microcircuit.

Pour ce faire, il est nécessaire que le matériau puisse enrober l'inlay sur ses deux faces.

A cet effet, on peut maintenir l'inlay au moyen de rainures ménagées dans les parois latérales du moule.

Afin que le matériau puisse se répandre au fond du moule, on peut, selon un premier mode de réalisation, percer des trous 201 réalisés dans l'inlay tel qu'illustré en figure 20 de manière à laisser couler du matériau sous l'inlay.

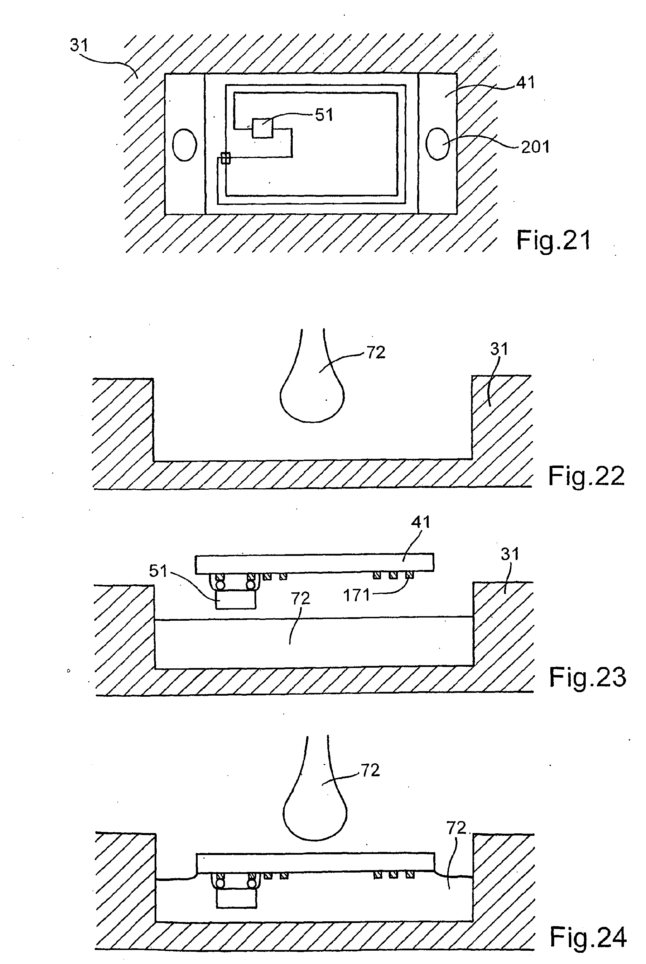

Selon une variante de réalisation, on prévoit que les côtés du moule ne soient pas recouverts par l'inlay tel qu'illustré en figure 21 de manière à laisser couler le matériau sous la couche de l'inlay.

Selon encore une autre variante de réalisation, on maintient l'inlay en position par le dépôt de gouttes de matériau.

Selon un autre mode de réalisation, on peut inclure l'inlay au sein de la carte par un procédé de fabrication en deux étapes.

Dans un premier temps, on dépose, par exemple par coulée, une première couche de matériau au fond du moule tel qu'illustré en figure 22. L'épaisseur de cette première couche correspond à peu près à la moitié de l'épaisseur de la carte souhaitée.

Ensuite, on positionne l'inlay sur la couche de matériau alors que cette couche est encore liquide tel que montré en figure 23.

Enfin, on dépose, notamment par coulée, une seconde couche sur l'inlay de sorte à ce que l'inlay soit positionné au sein du matériau de la carte tel qu'illustré en figure 24. L'épaisseur de cette seconde couche correspond à peu près à l'épaisseur de la première couche.

Selon ce mode de réalisation, l'inlay est positionné au milieu de l'épaisseur de la carte à microcircuit afin d'obtenir une carte à microcircuit ayant une structure symétrique.

Bien entendu, la présente invention n'est nullement limitée aux modes de réalisation décrits et représentés.

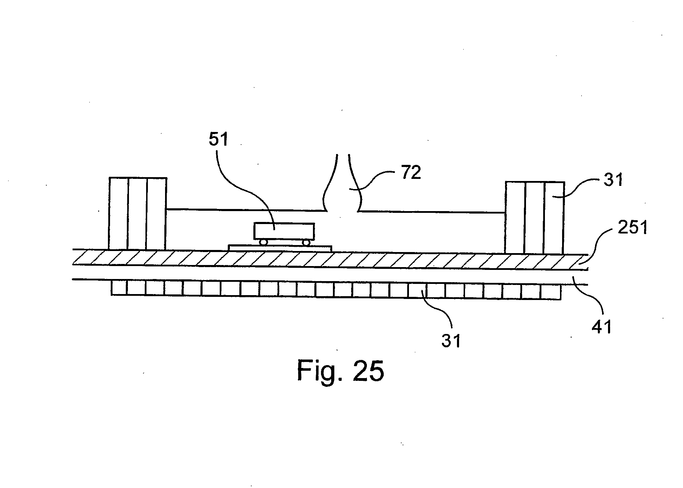

En effet, par exemple, la figure 25 illustre un mode de réalisation selon lequel le microcircuit est fixé sur un film de support 41 via une couche d'adhésif 251 positionnée sur la feuille de support 41.

Plus particulièrement, les contacts externes du microcircuit sont fixés sur un film de support 41 via la couche d'adhésif 251 positionnée sur la feuille de support 41

Selon ce mode de réalisation, le moule est constitué de deux parties. Une première partie comprend un support plan sur lequel vient reposer le film de support 41 et une seconde partie comprend une partie amovible définissant les dimensions latérales de la carte à microcircuit souhaitée.

Après avoir procédé au positionnement du film sur le support plan, la partie amovible du moule vient se rabattre sur le film tel que montré en figure 25.

Selon ce mode de réalisation, la couche d'adhésif maintient le microcircuit positionné sur le film et donc incidemment maintient le microcircuit correctement positionné dans le moule après positionnement du film.

On procède ensuite au dépôt de matériau dans le moule.

A l'issue de la fabrication, le matériau avec le microcircuit et le film de support est démoulé. Le film est ultérieurement retiré, de manière à libérer les contacts du microcircuit.

## Revendications

1. Procédé de fabrication d'une mini-carte à microcircuit comprenant les étapes suivantes :
- une étape de positionnement d'un microcircuit (44, 51, 61-63) dans un moule (31) à cavité ouverte,
- une étape de dépôt d'un matériau (72) liquide peu visqueux comprenant principalement une résine thermodurcissable dans la cavité ouverte du moule, la viscosité du matériau, étant suffisamment faible pour que le matériau enrobe au moins indirectement au moins une partie du microcircuit ;
- une étape de durcissement dudit matériau ; et
- une étape de démoulage du matériau une fois durci avec le microcircuit, **caractérisé en ce que** la quantité de matériau déposé est calculée de façon à remplir le moule jusqu'à atteindre le niveau d'épaisseur recherché pour la carte à microcircuit.

2. Procédé de fabrication selon la revendication 1, dans lequel la viscosité du matériau permet après dépôt d'obtenir une surface libre sensiblement lisse.

3. Procédé de fabrication selon la revendication 1 ou la revendication 2, dans lequel le dépôt est réalisé par coulée dans le moule.

4. Procédé de fabrication selon l'une quelconque des revendications précédentes, dans lequel la cavité ouverte du moule est de la forme de la carte à microcircuit.

5. Procédé de fabrication selon l'une quelconque des revendications précédentes, dans lequel le matériau comprend principalement une résine polyuréthane.

6. Procédé de fabrication selon l'une quelconque des revendications précédentes, comprenant de plus une étape de chauffage du matériau déposé et une étape de pré-chauffage du moule.

7. Procédé de fabrication selon l'une quelconque des revendications précédentes, comprenant en outre une étape de polymérisation, la résine étant choisie en sorte d'avoir, après l'étape de polymérisation, une température de transition vitreuse supérieure à 50°C.

8. Procédé de fabrication selon l'une quelconque des revendications précédentes, dans lequel l'étape de dépôt du matériau est réalisée postérieurement à l'étape de positionnement du microcircuit, le moule comprenant au moins un trou réalisé au fond du moule en vue de maintenir en position le microcircuit par aspiration.

9. Procédé de fabrication selon la revendication 8, dans lequel le microcircuit comprend des contacts externes, les contacts externes étant positionnés contre le fond du moule.

10. Procédé de fabrication selon l'une quelconque des revendications 1 à 9, dans lequel l'étape de dépôt du matériau est réalisée préalablement à l'étape de positionnement du microcircuit, ce microcircuit comprenant des contacts externes, les contacts externes étant positionnés au niveau de la surface du matériau déposé préalablement à un durcissement complet.

11. Procédé de fabrication selon l'une quelconque des revendications précédentes, dans lequel le microcircuit est fixé à un film de support.

12. Procédé de fabrication selon la revendication 11, dans lequel le film de support comporte en outre au moins une partie d'une antenne.

13. Procédé de fabrication selon l'une quelconque des revendications 1 à 7, dans lequel le microcircuit étant fixé sur un film de support, il y a une étape de fixation du film de support à un niveau intermédiaire dans le moule de sorte que le matériau enrobe le film de support et dans lequel le film de support comprend des trous permettant de répandre le matériau.

14. Procédé de fabrication selon l'une quelconque des revendications 1 à 7, dans lequel le microcircuit est fixé sur un film de support, le procédé comprenant les étapes suivantes :
- une étape de remplissage du fond du moule par un premier dépôt de matériau ;
- une étape de positionnement du film de support dans le matériau ;
- une étape consistant à recouvrir le film de support par remplissage dans le moule par un second dépôt de matériau.

15. Procédé de fabrication selon l'une quelconque des revendications 1 à 14, **caractérisé en ce que** le matériau (72) comprend un durcisseur.

16. Procédé de fabrication selon l'une des revendications 1 à 15, **caractérisé en ce que** la viscosité du matériau est inférieure à 10.000 mPa.s.

17. Procédé de fabrication selon l'une des revendications 1 à 16, **caractérisé en ce que** la carte est une carte SIM.

18. Procédé de fabrication selon l'une des revendications 1 à 16, **caractérisé en ce que** la carte est une carte SD.

19. Procédé de fabrication selon l'une des revendications 1 à 18 dans lequel le moule est en une seule partie.

20. Procédé de fabrication selon l'une des revendications 1 à 18 dans lequel le moule est constitué de deux parties, une première partie comportant un support plan sur lequel vient reposer un film de support et une seconde partie comprenant une partie amovible définissant les dimensions latérales de la carte.

21. Procédé de fabrication selon l'une des revendications 1 à 20 dans lequel un film de support est ultérieurement retiré.

## Claims

1. Microcircuit minicard production method comprising the following steps:
- a step of positioning a microcircuit (44, 51, 61-63) in an open cavity mould (31),
- a step of depositing a low viscosity liquid primarily comprising a thermosetting resin in the open cavity of the mould, the viscosity of the material being sufficiently low that the material coats at least indirectly at least a portion of the microcircuit;
- a step of hardening said material; and
- a step of extracting the material once hardened with the microcircuit from the mould, **characterized in that** the quantity of material deposited is calculated so as to fill the mould to the thickness level required for the microcircuit card.

2. Production method according to claim 1, wherein the viscosity of the material produces a substantially smooth free surface after deposition.

3. Production method according to claim 1 or claim 2, wherein deposition is effected by casting in the mould.

4. Production method according to any one of the preceding claims, wherein the open cavity of the mould is the shape of the microcircuit card.

5. Production method according to any one of the preceding claims, wherein the material primarily comprises a polyurethane resin.

6. Production method according to any one of the preceding claims, additionally including a step of heating the deposited material and a step of preheating the mould.

7. Production method according to any one of the preceding claims, further including a polymerization step, the resin being chosen to have, after the polymerization step, a glass transition temperature higher than 50°C.

8. Production method according to any one of the preceding claims, wherein the step of depositing the material is carried out after the step of positioning the microcircuit, the mould having at least one hole in the bottom of the mould for holding the microcircuit in position by suction.

9. Production method according to claim 8, wherein the microcircuit has external contacts that are positioned against the bottom of the mould.

10. Production method according to any one of claims 1 to 9, wherein the step of depositing the material is carried out before the step of positioning the microcircuit, this microcircuit having external contacts that are positioned on the surface of the deposited material before complete hardening.

11. Production method according to any one of the preceding claims, wherein the microcircuit is fixed to a support film.

12. Production method according to claim 11, wherein the support film further includes at least part of an antenna.

13. Production method according to any one of claims 1 to 7, wherein the microcircuit being fixed to a support film, there is a step of fixing the support film in the mould at an intermediate level so that the material coats the support film and wherein the support film includes holes enabling the material to spread.

14. Production method according to any one of claims 1 to 7, wherein the microcircuit is fixed to a support film, the method comprising the following steps:
- a step of filling the bottom of the mould with a first deposit of material;
- a step of positioning the support film in the material;
- a step of covering the support film by filling in the mould with a second deposit of material.

15. Production method according to any one of claims 1 to 14, **characterized in that** the material (72) comprises a hardener.

16. Production method according to one of claims 1 to 15, **characterized in that** the viscosity of the material is less than 10 000 mPa.s.

17. Production method according to one of claims 1 to 16, **characterized in that** the card is a SIM card.

18. Production method according to one of claims 1 to 16, **characterized in that** the card is an SD-card.

19. Production method according to one of claims 1 to 18, wherein the mould is in just one part.

20. Production method according to one of claims 1 to 18, wherein the mould is in two parts, a first part comprising a plane support on which a support film rests and a second part comprising a removable part defining the lateral dimensions of the card.

21. Production method according to one of claims 1 to 20 wherein a support film is subsequently removed.

## Patentansprüche

1. Verfahren zur Herstellung einer Minikarte mit Mikroschaltung bzw. Mikrochip-Minikarte, das die folgenden Schritte umfasst:
- einen Schritt der Positionierung eines Mikrochips (44, 51, 61-63) in einer Form (31) mit offener Kavität,
- einen Schritt des Ablagerns eines niedrigviskosen, flüssigen Materials (72), das hauptsächlich ein wärmehärtbares Harz umfasst, in der offenen Kavität der Form, wobei die Viskosität des Materials niedrig genug ist, damit es, zumindest mittelbar, mindestens einen Teil des Mikrochips umhüllt;
- einen Schritt des Härtens des Materials; und
- einen Schritt des Entformens des ausgehärteten Materials mit dem Mikrochip,
**dadurch gekennzeichnet, dass** die Menge abgelagerten Materials so kalkuliert ist, dass die Form so weit gefüllt wird, dass die für die Mikrochipkarte angestrebte Dicke erreicht wird.

2. Herstellungsverfahren nach Anspruch 1, wobei die Viskosität des Materials ermöglicht, nach seiner Ablagerung eine freie Oberfläche zu erhalten, die im Wesentlichen glatt ist.

3. Herstellungsverfahren nach Anspruch 1 oder Anspruch 2, wobei das Ablagern durch Gießen in die Form verwirklicht wird.

4. Herstellungsverfahren nach einem der vorhergehenden Ansprüche, wobei die offene Kavität der Form die Gestalt der Mikrochipkarte hat.

5. Herstellungsverfahren nach einem der vorhergehenden Ansprüche, wobei das Material hauptsächlich ein Polyurethanharz enthält.

6. Herstellungsverfahren nach einem der vorhergehenden Ansprüche, das des Weiteren einen Schritt des Erwärmens des abgelagerten Materials und einen Schritt des Vorwärmens der Form umfasst.

7. Herstellungsverfahren nach einem der vorhergehenden Ansprüche, das außerdem einen Polymerisationsschritt umfasst, wobei das Harz so gewählt ist, dass nach dem Polymerisationsschritt eine über 50°C liegende Glasübergangstemperatur erhalten wird.

8. Herstellungsverfahren nach einem der vorhergehenden Ansprüche, wobei der Schritt des Ablagerns des Materials später als der Schritt des Positionierens des Mikrochips ausgeführt wird, weshalb die Form mindestens ein Loch aufweist, das im Boden der Form ausgeführt ist, um den Mikrochip durch Ansaugen in Position zu halten.

9. Herstellungsverfahren nach Anspruch 8, wobei der Mikrochip äußere Kontakte umfasst, welche am Boden der Form anliegend angeordnet werden.

10. Herstellungsverfahren nach einem der Ansprüche 1 bis 9, wobei der Schritt des Ablagerns des Materials vor dem Schritt des Positionierens des Mikrochips ausgeführt wird, wobei dieser Mikrochip externe Kontakte umfasst, welche vor einem vollständigen Aushärten in gleicher Höhe mit der Oberfläche des aufgebrachten Materials angeordnet werden.

11. Herstellungsverfahren nach einem der vorhergehenden Ansprüche, wobei der Mikrochip auf einem Trägerfilm fixiert ist.

12. Herstellungsverfahren nach Anspruch 11, wobei der Trägerfilm außerdem mindestens einen Teil einer Antenne aufweist.

13. Herstellungsverfahren nach einem der Ansprüche 1 bis 7, wobei der Mikrochip auf einem Trägerfilm fixiert ist und es einen Schritt der Fixierung des Trägerfilms auf einer mittleren Höhe in der Form gibt, damit das Material den Trägerfilm umhüllt, und wobei der Trägerfilm Löcher aufweist, die ein Verteilen des Materials ermöglichen.

14. Herstellungsverfahren nach einem der Ansprüche 1 bis 7, wobei der Mikrochip auf einem Trägerfilm fixiert ist und wobei das Verfahren die folgenden Schritte umfasst:
- einen Schritt des Befüllens des unteren Teils der Form durch eine erste Materialablagerung;
- einen Schritt des Positionierens des Trägerfilms in dem Material;
- einen Schritt, der darin besteht, durch Befüllen der Form mit einer zweiten Materialablagerung den Trägerfilm zu bedecken.

15. Herstellungsverfahren nach einem der Ansprüche 1 bis 14, **dadurch gekennzeichnet, dass** das Material (72) einen Härter enthält.

16. Herstellungsverfahren nach einem der Ansprüche 1 bis 15, **dadurch gekennzeichnet, dass** die Viskosität des Materials niedriger als 10 000 mPa.s ist.

17. Herstellungsverfahren nach einem der Ansprüche 1 bis 16, **dadurch gekennzeichnet, dass** die Karte eine SIM-Karte ist.

18. Herstellungsverfahren nach einem der Ansprüche 1 bis 16, **dadurch gekennzeichnet, dass** die Karte eine SD-Karte ist.

19. Herstellungsverfahren nach einem der Ansprüche 1 bis 18, **dadurch gekennzeichnet, dass** die Form einteilig ist.

20. Herstellungsverfahren nach einem der Ansprüche 1 bis 18, wobei die Form aus zwei Teilen gebildet ist, einem ersten Teil, der einen planen Träger aufweist, auf dem ein Trägerfilm zu liegen kommt, und einem zweiten Teil, der einen abnehmbaren Teil umfasst, der die Seitenabmessungen der Karte bestimmt.

21. Herstellungsverfahren nach einem der Ansprüche 1 bis 20, wobei ein Trägerfilm zu einem späteren Zeitpunkt abgezogen wird.
